(19) **Europäisches Patentamt**
**European Patent Office**
**Office européen des brevets**

(11) **EP 2 132 013 B1**

(12) **EUROPEAN PATENT SPECIFICATION**

(45) Date of publication and mention
of the grant of the patent:
**08.02.2012 Bulletin 2012/06**

(51) Int Cl.:
*B28B 3/00* (2006.01)     *C07K 14/47* (2006.01)
*C01G 5/00* (2006.01)     *C30B 29/02* (2006.01)
*C30B 7/00* (2006.01)     *C30B 29/60* (2006.01)

(21) Application number: **08724294.7**

(22) Date of filing: **27.03.2008**

(86) International application number:
**PCT/SE2008/050348**

(87) International publication number:
**WO 2008/118094 (02.10.2008 Gazette 2008/40)**

(54) **METHOD FOR THE MANUFACTURE OF THIN METAL NANOWIRES BY BIOTEMPLATING**

VERFAHREN ZUR HERSTELLUNG VON DÜNNE METALLNANODRÄHTE DURCH BIOTEMPLATING

PROCÉDÉ POUR LA FABRICATION DE NANOFILS MÉTALLIQUES FINS PAR MATRIÇAGE BIOLOGIQUE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **27.03.2007 US 908200 P**

(43) Date of publication of application:
**16.12.2009 Bulletin 2009/51**

(73) Proprietors:
• **Morozova-Roche, Ludmilla**
**907 41 Umeå (SE)**
• **Malisauskas, Mantas**
**5613 EG Eindhoven (NL)**

(72) Inventors:
• **Morozova-Roche, Ludmilla**
**907 41 Umeå (SE)**
• **Malisauskas, Mantas**
**5613 EG Eindhoven (NL)**

(74) Representative: **Fagerlin, Heléne et al**
**Albihns.Zacco**
**Valhallavägen 117**
**Box 5581**
**114 85 Stockholm (SE)**

(56) References cited:
**EP-A2- 1 264 919     US-A1- 2007 059 727**

• **RECHES M. ET AL.: 'Casting Metal Nanowires Within Discrete Self-Assembled Peptide Nanotubes' SCIENCE vol. 300, 25 April 2003, pages 625 - 627, XP002276672**
• **HAMADA D. ET AL.: 'Engineering amyloidogenicity towards the development of nanofibrillar materials' TRENDS IN BIOTECHNOLOGY vol. 22, no. 2, February 2004, pages 93 - 97, XP004486418**
• **SCHEIBEL T. ET AL.: 'Conducting nanowires built by controlled self-assembly of amyloid fibers and selective metal deposition' PNAS vol. 100, no. 8, 15 April 2003, pages 4527 - 4532, XP001180754**
• **SONG Y. ET AL.: 'Synthesis of peptide-nanotube platinum-nanoparticle composites' CHEM. COMMUN. 2004, pages 1044 - 1045, XP003023476**
• **PADALKAR S. ET AL.: 'Alpha-synuclein as a template for the synthesis of metallic nanowires' NANOTECHNOLOGY vol. 18, 2007, pages 1 - 9, XP020119814**
• **GAZIT E.: 'Use of biomolecular templates for the fabrication of metal nanowires' FEBS JOURNAL vol. 274, 2007, pages 317 - 322, XP003023477**

## Description

### Field of the invention

The present invention provides methods for the manufacturing of metal nanowires using protein fibrils as biotemplates. The methods comprise use of a solvent providing a dual effect by promoting the formation of protein fibrils of suitable size as well as acting as a reducing agent. The invention further provides metal nanowires produced by the methods according to the invention.

### Background of the invention

The main challenge in the growing field of nanotechnology is the fabrication of nanosized structures with controlled parameters. Nature provides us with an inspiration how to achieve this goal. The self-assembly of biological macromolecules into larger polymers and complexes with diverse structures is a very common event in live organisms. This phenomenon can be successfully explored for developing templates to cast inorganic nanostructures.

The ultra-thin nanowires are in great need for constructions of the conductive circuits in nano-scale electronics. The self-assembling biotemplates may enable us to grow the nano-structures directly in the required places in the nano-devices avoiding the stage of their positioning and micro-manipulations. The biotemplating involves two major steps; firstly, the regular and hierarchical assembly of biological molecules into the structural scaffold and then incorporation of the inorganic component with required properties. There are a number of previous attempts to use biotemplates for this purpose, among them the DNA molecules are most widely explored for manufacturing of conductive metal nanowires with diameters in the range of 20 to 100 nm and the lengths of 0.5 to 12 $\mu$m[1-3]. Utilization of viral capsids led to the synthesis of conductive and magnetic nanowires with 3 to 25 nm diameters, but the length was limited to a few hundred nanometers by the dimensions of capsids[4-6]. Recently, protein complexes have also been subjected to biotemplating. The polymerization of G-actin labelled with gold nanoparticles, followed by the catalytic enlargement of the nanoparticles, yielded gold wires of 80-200 nm diameter and 1-4 $\mu$m in length[7]. The principle of metal coating of the biotemplates with silver and gold was used with genetically modified prion amyloid fibrils as templates, resulting in conducting wires of 100 nm diameter[8]. Another approach of casting silver nanowires inside the hollow part of chemically synthesized dipeptide nanotubes produced the wire of ca. 20 nm in diameter[9].

Over the last two decades the extensive studies of amyloids led to the concept that any polypeptide can assemble into this type of polymers as an alternative to its native functionally active conformation[10,11]. The amyloids possess a distinctive structural feature such as cross-$\beta$-sheet core packed by polypeptide chain and supported by a dense network of hydrogen bonding as well as by hydrophobic stacking of aromatic side-chains[12]. Consequently, amyloids are remarkably stable towards mechanical damage and chemical denaturation over a wide range of conditions, far exceeding similar properties of other macromolecules such as DNA[8]. Such properties make them particularly attractive for biotechnological applications, particularly as there is an unlimited natural source of these species. Lysozyme is a ubiquitous protein, which, can readily polymerize under tightly controlled conditions into regular and unbranched fibrous structures growing up to 10 $\mu$m in length[13,14].

### Brief description of the invention

The present invention provides methods for the manufacturing of metal nanowires using protein fibrils as templates. The methods comprise the use of a solvent providing a dual effect by promoting the formation of protein fibrils of suitable size as well as acting as a reducing agent.

We applied naturally-occurring cross-$\beta$-sheet containing proteinaceous polymers known as amyloids to produce scaffolds for moulding silver nanowires. The diameter of the nanowires was within 1.0-2.5 nm and reached 1-1.5 $\mu$m length. Up to date this is the thinnest silver nanowires produced by biotemplating. These results demonstrate that the biotemplating expands boundaries for the nanoparticles production from tens to sub-nanometer scale, opening new horizons in quantum electronics. They provide also an insight into the packing of amyloid core, demonstrating the absence of the cavities within individual fibrils.

Accordingly, the present invention provides a method as set forth in claim 1 for the manufacture of metal nanowires, the method comprising incubating protein fibrils in a solution of a metal salt in a solvent, said solvent having a hydrophobic constant, logP, between 0 and 3.0 and further having a standard reducing potential, $E_0$, between 0 volts and 1.5 volts, allowing the formation of metal nanowires on the protein fibril templates.

The method can further comprise proteinase digestion of the protein fibril template following the formation of the metal nanowire. Proteinase digestion can be made by the use of proteinase K, other serine proteases like trypsin, $\alpha$-chymotrypsin, $\beta$-chymotrypsin and subtilisin; cysteine proteases like bromelain, papain, chymopapain, ficin and sortase A, or aspartic proteases like rennin and pepsin.

Formation of protein fibril template is promoted by the use of a hydrophobic solvent. The solvent can have a hydrophobic constant, log P, defined as the log of the partition coefficient between octanol and water, which is between 0 and 3.0, preferably between 0.2 and 1.0, and even more preferably between 0.3 and 0.5.

$$\text{Log P}_{octanol/water} = \log \left( \frac{\text{concentration of solvent in octanol}}{\text{concentration of solvent in water}} \right)$$

The solvent can have a standard reducing potential, $E_0$, between -0.2 volts and 1.5 volts, preferably between 0 volts and 0.8 volts, such as between 0.1 volts and 0.7 volts, or even more preferably 0.2 volts and 0.6 volts.
A solvent with a lower reducing potential within the above ranges can be selected for the reduction of a metal with a lower reducing potential, e.g. silver having a reducing potential of 0.8 volts, a solvent with a higher reducing potential within the above ranges can be selected for the reduction of a metal with a higher reducing potential, e.g. gold having a reducing potential of 1.7 volts.
The solvent can be a halogenated alcohol, preferably a fluorinated alcohol. The fluorinated alcohol can be selected from a fluorinated ethanol, propanol, butanol, pentanol, hexanol, heptanol, octanol. The alcohol can be a mono, di-, tri-, tetra-, penta-, hexa-, hepta-, octa-, or nona-fluorinated alcohol.
The solvent can be selected from
2-Fluoroethanol,
2,2-Difluoroethanol,
2,2,2-Trifluoroethanol,
1,1,1-Trifluoro-2-propanol,
3,3,3-Trifluoro-1-propanol,
Hexafluoro-2-propanol,
2,2,3,3-Tetrafluoro-1-propanol,
2,2,3,3,3-Pentafluoro-1-propanol,
4,4,4-Trifluoro-1-butanol,
2,2,3,4,4,4-Hexafluoro-1-butanol,
2,2,3,3,4,4,4-Heptafluoro-1-butanol,
3,3,4,4,4-Pentafluoro-2-butanol,
1,1,1,3,3-Pentafluoro-2-butanol,
5,5,5-Trifluoro-1-pentanol,
4,4,5,5,5-Pentafluoro-1-pentanol,
2,2,3,3,4,4,5,5-Octafluoro-1-pentanol,
6,6-Difluoro-1-hexanol,
7,7, 7-Trifluoro-1-heptanol,
1,1,1-Trifluoro-2-octanol,
2,2,3,3-Tetrafluoro-1-octanol.
The protein fibrils are preferably amyloid fibrils.
The protein fibrils can be selected from lysozyme fibrils, Alzheimer β-amyloids fibrils, prion fbrils, insulin fibrils, bovine α-lactalbumin fibrils, S100A8 fibrils, S100A9 fibrils, α-synuclein fibrils.
The nanowire can be manufactured from a noble metal, i.e. silver, gold, platinum or palladium, or from another suitable metal such as copper.
The metal salt can be provided as any suitable salt, such as a nitrate, nitrite, carbonate, chloride, bromide, fluoride, iodide, acetate, sulphate.
The method of the invention further provides metal nanowires.
The metal nanowires have a diameter of less than 3 nm, preferably less than 2 nm.
The metal nanowires have a length of more than 0.5 $\mu$m, preferably more than 1 $\mu$m, or even more preferably more than 2 $\mu$m.

**Brief description of the figures.**

Figure 1. Scheme of casting silver nanowires within amyloid scaffolds.

Figure 2. Silver nanoparticles formation by TFE reduction. Time course of silver reduction by TFE monitored by absorbance spectroscopy (a). The atomic force microscopy (AFM) images of the silver nanoparticles formed in TFE and the distributions of their sizes measured by AFM after 2 hours (b, c) and 72 hours (d, e) of incubation, respectively.

Figure 3. Silver nanowire formation in amyloid scaffolds. Thioflavin T binding by different amyloids measured by fluorescence (a). AFM images of original lysozyme amyloid fibrils (b); amyloid scaffolds incubated in TFE with silver (c) and without silver (e); silver nanowires released from the scaffolds after proteinase K digestion (d); the digestion of empty amyloid scaffolds by proteinase K (f).

Figure 4. AFM images of ultra thin silver nanowires, a network of silver nanowires (a), a single silver nanowire (b), the distribution of diameters of silver nanowires measured by AFM (c).

Figure 5. AFM images of amyloids with reducing agents. Amyloids in N,N-dimethylfomiamide (DMF) (a) and in citric acid (b).

**Detailed description of the invention**

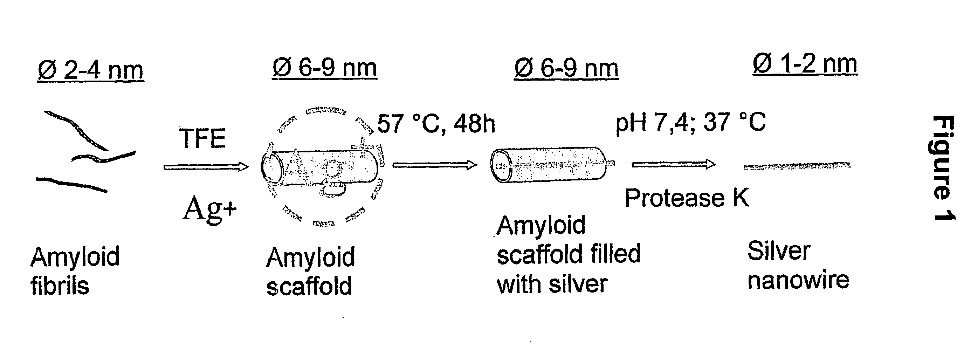

The method used for nanowire production is outlined in Figure 1. According to the method of the invention two critical events, i.e. metal reduction and assembly of the nanowire within the biotemplate mould occur concomitantly. A key factor in this procedure is the use of a solvent exhibiting a dual effect, both promoting the formation of protein fibrils of suitable size, and acting a reducing agent, the solvent being exemplified by 2,2,2-trifluoroethanol (TFE).

Firstly, it is demonstrated that the solvent reduces ionic silver into colloidal form following the reaction (1):

$$2\ Ag^+\ CF_3\text{-}CH_2\text{-}OH \rightarrow 2\ Ag°+ CF_3\text{-}CHO + 2H^+ \qquad (1)$$

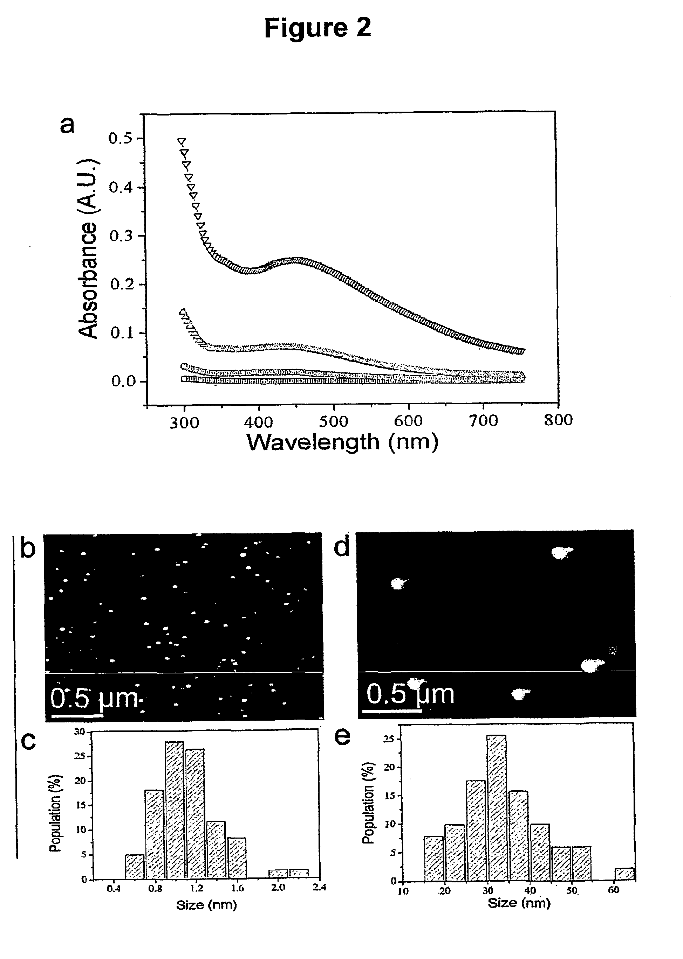

The reaction was monitored by changes of the absorbance spectra of the solution (Figure 2a), which were also corroborated by the colour developing from fully uncoloured to yellow/brown[15]. The samples were analysed by AFM, demonstrating the formation of uniform silver nanoparticles. Their size depended on the reduction time; 1.2 nm particles were formed after 2 hours and 35 nm after 72 hours, respectively (Figure 2b - 2e).

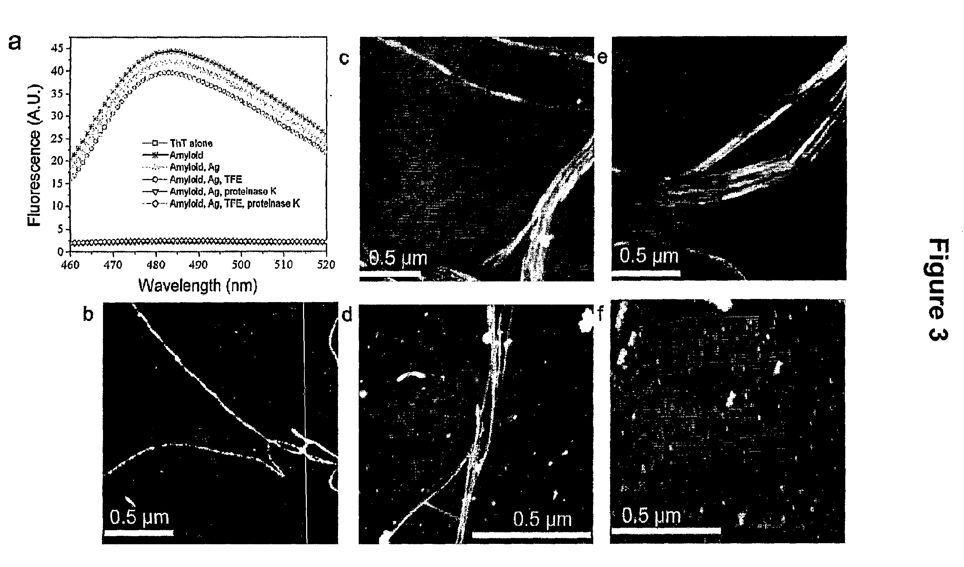

Secondly, the solvent induces the lateral assembly of individual protein fibrils into larger and thicker scaffolds, which trap silver in inter-fibrillar space and serve a role of the moulds. Before treatment with TFE the amyloid fibrils were characterised by 2-4 nm height in AFM images (Figure 3b), exhibiting typical amyloid tinctorial features such as thioflavin T dye binding[16,17] (Figure 3a). After incubation with TFE in the presence and absence of silver ions fibrils become thicker with ca 6-9 nm height (Figure 3c, 3e), which corroborated with a slight decrease in thioflavin T binding due to a decrease in number of exposed thioflavin T binding sites (Figure 3a). In the fibrillar sample containing silver the yellow-brown colour was developed, indicating silver reduction.

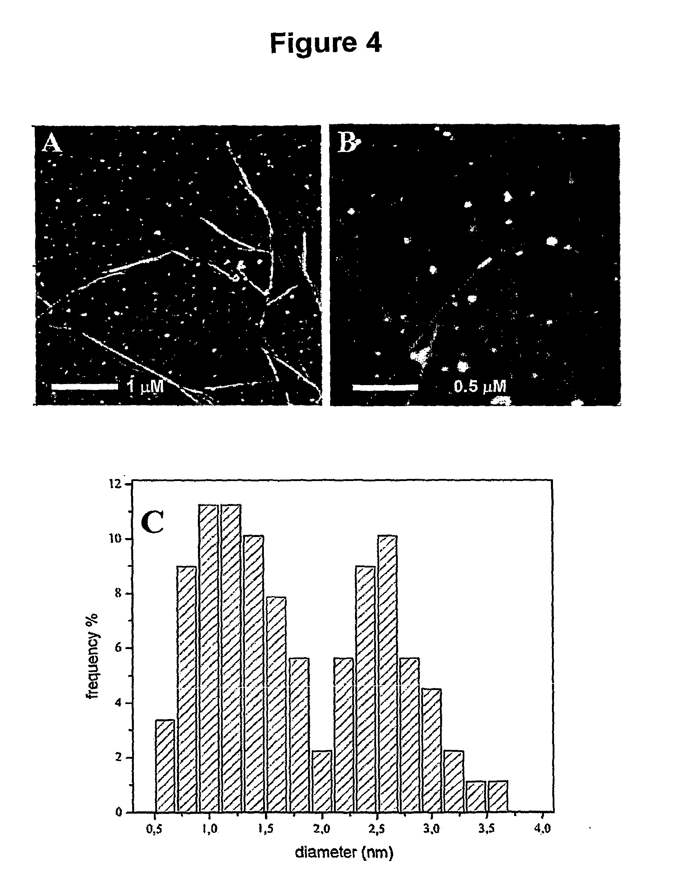

In order to verify formation of silver nanowires, the proteinaceous moulding scaffolds were digested by proteinase K. In the sample without silver, the amyloid was fully removed after 24 hours of proteinase treatment. This was conformed by the drop of the thioflavin T signal to the level of free dye in solution (Figure 3a) and by AFM (Figure 3e). In the sample where the silver nanowires were cast in the amyloid scaffold, the nanowires were released and observed by AFM (Figure 3d), while the thioflavin T signal also disappeared, indicating the degradation of amyloid structures (Figure 3a). The nanowires were characterised by having a diameter of 1-2.5 nm and a variable length from 0.5 to ca. 2 $\mu$m (Figure 3). The nanowires were straight or banded and sometimes a few nanowires were twisted around each other (Figure 3d, figure 4).

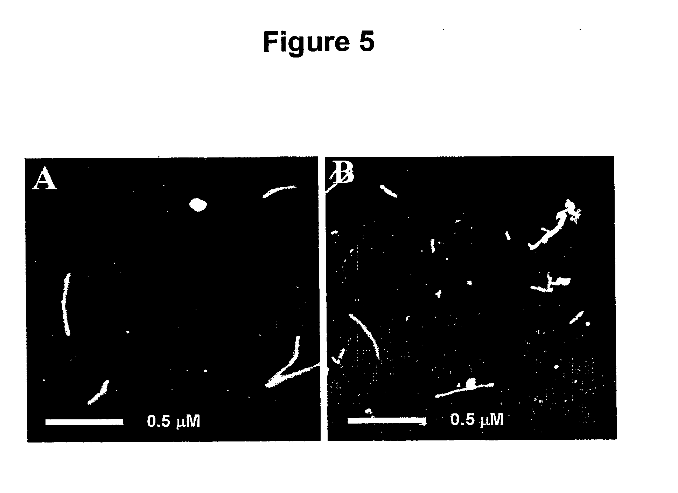

In control experiments the amyloids in the presence of AgNO$_3$ were treated with the reducing agents N,N-dimethylformamide (DMF) or citric acid. While both agents initiated the formation of silver nanoparticies[9,15] they did not induce fibril thickening, but rather caused their fragmentation to shorter species of 0.5-1 $\mu$m length and 2-4 nm in height (Figure 5). Consequently, after the treatment with proteinase K all amyloid material was removed but the silver nanowires were not detected. This indicates that fibrillar lateral assembly and formation of the structured, hollow fibrillar interface is essential for silver moulding, whiles the individual fibrils with a common diameter of 2 nm and less do not possess such a cavity.

Thus, naturally occurring proteinaceous amyloid polymers assembled into larger scaffolds can be used for casting metal nanostructures. This has been utilised for this purpose an abundant and cheep material such as hen lysozyme. The limit in biotemplating producing the ultra thin silver nanowire of ca. 1 nm diameter has been reached, which is significantly below the dimensions attainable by standard electronic manufacturing processes and also one order of magnitude thinner than nanowires fabricated using other proteinaceous scaffolds[8,9]. The method according to the present invention allows removing the moulding scaffold by proteinase digestion compared to other approaches, in which the protein polymers remain within the formed metal wires[8].

For the first time it is surprisingly demonstrated that a fluorinated alcohol, TFE, can be used as a reducing agent and has potential applications in manufacturing metal nanoparticles. The major advantage of the methods according to the invention is the use of a solvent such as TFE, which compared to other combinations of solvents and reducing agents induces formation and stabilization of protein fibril scaffold simultaneously with metal ion reduction. Less suited reducing agents, such as citric acid and DMF causes fragmentation of the protein fibrils without the formation of metal nanowires.

The process of biotemplating can be used as a tool to get an insight on the properties of the scaffold itself, according to the present invention on amyloid. By analysing the X-ray diffraction pattern of fibrillar amyloids, Perutz and co-authors suggested that the amyloid fibrils are probably built of a few concentric cylindrical β-sheets containing the hollow part filled with water[18]. This hypothesis was supported by production of synthetic dipeptide amyloid-like nanotubes and filling them with silver of ca. 20 nm diameter[9]. However, the NMR-based analysis of amyloid fibrils of Aβ peptide and prions indicate the dense packing within fibrillar interior, which rules out the cavity in the protofilament core[19,20]. In this light the data directly demonstrate the absence of the hollow part within the individual amyloid fibrils, unlike synthetic peptide nanotubes, prior their assembly into the larger scaffold.

The methods according to the invention can be used to form nanowires from a noble metal, such as silver, gold, platinum, and palladium, or other suitable metal such as copper.

The methods according to the invention can be used to produce nanoparticles with controlled dimensions.

**Materials and methods.**

*Materials*

Hen egg white lysozyme was purchased from Sigma (USA). Amyloid was produced by incubation of protein in 20 mM glycine buffer at pH 2.5, 57°C. Proteinase K was purchased from Fementas (Lithuania). DMF, TFE and citric acid were purchased from Fluka (Germany).

*Thioflavin T binding assay.*

Thioflavin T binding amyloid assay was carried out as described previously[13]. Fluorescence measurements were performed on a Jasco spectrofluorometer FP 6500, using excitation at 440 nm and measuring emission between 460 and 520 nm.

*Atomic Force Microscopy.*

AFM measurements were performed on a PICO PLUS microscope (Molecular Imaging, USA) in a tapping mode using a 100 $\mu$m scanner with acoustically driven cantilevers operating at a resonance frequency in 320-370 kHz range. Scanning resolution was 512x512 pixels. The scanning was performed in trace and retrace to avoid the scan artefacts. Specimens were diluted in MiliQ water, incubated on freshly cleaved mica for 10 min, subsequently washed 2 X 200 $\mu$l with MiliQ water and dried over night at room temperature. The parameters of nanostructures were measured by using a Scanning Probe Image Processor software (Image Metrology, Denmark).

*Reduction of silver.*

The stock of 1M $AgNO_3$ in MiliQ water was diluted to a final concentration of 20 mM with the excess of appropriate reducing agents such as TFE, DMF or citric acid and subsequently incubated at 57°C for 72 hours. Reduction of silver was estimated by measuring absorbance spectra at 300-700 nm on a Lambda 40 spectrophotometer (Perkin Elmer, USA) as described previously[15].

*Casting silver nanowires in amyloid fibrils.*

Amyloid fibrils were sedimented for 30 min at 12000 g on a minicentrifuge (Eppendorf, Germany). The pellet was resuspended in 100 $\mu$l MiliQ water and sedimented again. $AgNO_3$ was added to the fibrillar pellet to 20 mM final concentration and the sample was incubated at room temperature for 24 h. The fibrils were centrifuged and an access of reducing agent was added to the pellet, following incubation for 48 h at 57°C. The complexes were centrifuged, resuspended at 100 mM Tris-HCl pH 7.4 and 0.2 mg/ml protease K was added for 24 h at 37°C in order to achieve the full digestion of the amyloid scaffold. Consequently, the samples were analysed by AFM and ThT binding assay.

**References**

1. Braun, E., Eichen. Y., Sivan, U. & Ben-Yoseph, G. DNA-templated assembly and electrode attachment of a conducting silver wire. Nature 391, 775 - 778 (1998).

2. Stoltenberg, R. M. & Woolley, A. T. DNA-templated nanowire fabrication Biomed. Microdevices 6, 105 - 111 (2004).

3. Berti, L., Alessandrini, A. & Facci, P. DNA-templated photoinduced silver deposition. J. Am. Chem. Soc. 127, 11216 - 11217, (2005).

4. Knez, M, et al. Biotemplate synthesis of 3-nm nickel and cobalt nanowires. Nano Lett. 3, 1079 - 1082 (2003)

5. Baici, S., et al. Copper nanowires within the central channel of tobacco mosaic virus particles. Electrochim. Acta 51, 6251 - 6257 (2006).

6. Mao, C. et al. Virus-based toolkit for the directed synthesis of magnetic and semiconducting nanowires. Science 303, 213 - 217 (2004).

7. Patolsky. F., Weizmann, Y. & Willner, I. Actin-based metallic nanowires as bionanotransporters. Nat. Mater. 3, 692 - 695 (2004).

8. Scheibel, T et al. Conducting nanowires built by controlled self-assembly of amyloid fibers and selective metal deposition Proc. Natl. Acad. Sci. USA 100, 4527 - 4532 (2003).

9. Reches, M. & Gazit, E. Casting metal nanowires within discrete self-assembled peptide nanotubes. Science 300, 625 - 627 (2003).

10. Dobson, C. M. Protein folding and its links with human disease. Biochem. Soc. Symp. 68, 1 - 26 (2001).

11. Chiti, F. & Dobson, C. M. Protein misfolding, functional amyloid, and human disease. Annu. Rev. Biochem. 75, 333 - 366 (2006).

12. Jimenez, J. L. et al. Cryo-electron microscopy structure of an SH3 amyloid fibril and model of the molecular packing. EMBO J. 18, 815 - 821 (1999).

13. Morozova-Roche, L. A. et al. Amyloid fibril formation and seeding by wild-type human lysozyme and its disease-related mutational variants. J. Struct. Biol. 130, 339 - 351 (2000).

14. Krebs, M. R. et al. Formation and seeding of amyloid fibrils from wild-type hen lysozyme and a peptide fragment from the β-domain. J Mol. Biol. 300, 541 - 549 (2000).

15. Pastoriza-Santos, L & Liz-Marzán, L. M. Reduction of silver nanoparticles in DMF. Formation of monolayers and stable colloids. Pure Appl. Chem. 72, 83 - 90 (2000).

16. LeVine, H. 3rd. Thioflavine T interaction with synthetic Alzheimer's disease beta-amyloid peptides: detection of amyloid aggregation in solution. Protein Sci. 2, 404 - 410 (1993).

17. Krebs, M. R., Bromley, E. H. & Donald, A. M. The Binding of thioflavin-T to amyloid fibrils: localisation and implications. J. Struct. Biol., 149, 30 - 37 (2005).

18. Perutz, M. F., Finch, J. T., Berriman, J. & Lesk, A. Amyloid fibers are water-filled nanotubes. Proc. Natl. Acad. Sci. USA 99, 5591 - 5595 (2002).

19. Olofsson, A., Lindhagen-Persson, M., Sauer-Eriksson, A. E. & Ohman A. Amide solvent protection analysis demonstrate that Amyloid-β (1-40) and Amyloid-β (1-42) form different fibrillar structures under identical conditions. Biochem J. 404, 63 - 70 (2007).

20. Petkova, A. T., Yau, W. M. & Tycko, R. Experimental constraints on quaternary structure in Alzheimer's β-amyloid fibrils. Biochemistry 45, 498 - 512 (2006).

**Claims**

1.  A method for the manufacture of metal nanowires, said method comprising incubating protein fibrils in a solution of a metal salt in a solvent, said solvent having a hydrophobic constant, logP, between 0 and 3.0 and further having a standard reducing potential, $E_0$, between 0 volts and 1.5 volts, providing a dual effect by promoting the formation of protein fibrils of suitable size as well as acting as a reducing agent allowing the formation of metal nanowires on the protein fibril templates.

2.  The method according to claim 1 further comprising proteinase digestion of the protein fibril template following the formation of the metal nanowires.

3.  The method according to claim 2 wherein the proteinase digestion is made by the use of a proteinase selected from proteinase K, a serine protease such as trypsin, α-chymotrypsin, β-chymotrypsin and subtilisin; a cysteine protease such as bromelain, papain, chymopapain, ficin and sortase A, and an aspartic protease like rennin and pepsin.

4. The method according to claim 1 wherein the solvent has a hydrophobic constant, log P, which is between 0 and 3.0, preferably between 0.2 and 1.0, and even more preferably between 0.3 and 0.5.

5. The method according to claim 1 wherein the solvent has a standard reducing potential, E0, between 0 volts and 1.5 volts, preferably between 0 volts and 0.8 volts, such as between 0.1 volts and 0.7, or even more preferably between 0.2 volts and 0.6 volts.

6. The method according to claim 1 wherein the solvent is a fluorinated alcohol.

7. The method according to claim 1 wherein the solvent is selected from a fluorinated ethanol, propanol, butanol, pentanol, hexanol, heptanol, octanol.

8. The method according to claim 1 wherein the solvent is selected from
2-Fluoroethanol,
2,2-Difluoroethanol,
2,2,2-Trifluoroethanol,
1,1,1-Trifluoro-2-propanol,
3,3,3-Trifluoro-1-propanol,
Hexafluoro-2-propanol,
2,2,3,3-Tetrafluoro-1-propanol,
2,2,3,3,3-Pentafluoro-1-propanol,
4,4,4-Trifluoro-1-butanol,
2,2,3,4,4,4-Hexafluoro-1-butanol,
2,2,3,3,4,4,4-Heptafluoro-1-butanol,
3,3,4,4,4-Pentafluoro-2-butanol,
1,1,1,3,3-Pentafluoro-2-butanol,
5,5,5-Trifluoro-1-pentanol,
4,4,5,5,5-Pentafluoro-1-pentanol,
2,2,3,3,4,4,5,5-Octafluoro-1-pentanol,
6,6-Difluoro-1-hexanol,
7,7,7-Trifluoro-1-heptanol,
1,1,1-Trifluoro-2-octanol,
2,2,3,3-Tetrafluoro-1-octanol.

9. The method according to claim 6 wherein the solvent is 2,2,2-Trifluoroethanol.

10. The method according to claim 1 wherein the protein fibrils are selected from lysozyme fibrils, Alzheimer β-amyloid fibrils, prion fibrils, insulin fibrils, bovine alpha-lactalbumin fibrils, S100A8 fibrils, S100A9 fibrils, and alpha-synuclein fibrils.

11. The method according to claim 1 wherein the metal is selected from a noble metal, such as silver, gold, or platinum, and copper.

12. The method according to claim 1 wherein the metal salt is selected from a nitrate, nitrite, carbonate, chloride, bromide, fluoride, iodide, acetate, sulphate.

13. The method according to claim 1 wherein the metal is silver.

14. The method according to claim 1 wherein the metal is silver and the solvent is 2,2,2-Trifluoroethanol.

**Patentansprüche**

1. Ein Verfahren zur Herstellung von Metallnanodrähten, wobei das Verfahren Inkubieren von Proteinfibrillen in einer Lösung eines Metallsalzes in einem Lösungsmittel umfasst, wobei das Lösungsmittel, das eine hydrophobe Konstante, log P, zwischen 0 und 3,0 aufweist und weiter ein Standardreduktionspotential, $E_0$, zwischen 0 Volt und 1,5 Volt aufweist, einen Doppeleffekt bereitstellt, indem es die Bildung von Proteinfibrillen mit geeigneter Größe fördert sowie als Reduktionsmittel dient, was die Bildung von Metallnanodrähten auf den Proteinfibrillenmatrices erlaubt.

**2.** Das Verfahren nach Anspruch 1, weiter umfassend Proteinaseaufschluss der Proteinfibrillenmatrix im Anschluss an die Bildung der Metallnanodrähte.

**3.** Das Verfahren nach Anspruch 2, wobei der Proteinaseaufschluss durch die Verwendung einer Proteinase erfolgt, ausgewählt aus Proteinase K, einer Serinprotease wie Trypsin, α-Chymotrypsin, β-Chymotrypsin und Subtilisin; einer Cysteinprotease wie Bromelain, Papain, Chymopapain, Ficin und Sortase A, und einer Asparaginprotease wie Rennin und Pepsin.

**4.** Das Verfahren nach Anspruch 1, wobei das Lösungsmittel eine hydrophobe Konstante, log P, aufweist, die zwischen 0 und 3,0, vorzugsweise zwischen 0,2 und 1,0, und noch stärker bevorzugt zwischen 0,3 und 0,5 liegt.

**5.** Das Verfahren nach Anspruch 1, wobei das Lösungsmittel ein Standardreduktionspotential, $E_0$, zwischen 0 Volt und 1,5 Volt, vorzugsweise zwischen 0 Volt und 0,8 Volt, wie z.B. zwischen 0,1 1 Volt und 0,7 Volt, oder noch stärker bevorzugt zwischen 0,2 Volt und 0,6 Volt, aufweist.

**6.** Das Verfahren nach Anspruch 1, wobei das Lösungsmittel ein fluorierter Alkohol ist.

**7.** Das Verfahren nach Anspruch 1, wobei das Lösungsmittel aus einem fluorierten Ethanol, Propanol, Butanol, Pentanol, Hexanol, Heptanol, Octanol ausgewählt ist.

**8.** Das Verfahren nach Anspruch 1, wobei das Lösungsmittel ausgewählt ist aus
2-Fluorethanol,
2,2-Difluorethanol,
2,2,2-Trifluorethanol,
1,1,1-Trifluor-2-propanol,
3,3,3-Trifluor-1-propanol,
Hexafluor-2-propanol,
2,2,3,3-Tetrafluor-1-propanol,
2,2,3,3,3-Pentafluor-1-propanol,
4,4,4-Trifluor-1-butanol,
2,2,3,4,4,4-Hexafluor-1-butanol,
2,2,3,3,4,4,4-Heptafluor-1-butanol,
3,3,4,4,4-Pentafluor-2-butanol,
1,1,1,3,3-Pentafluor-2-butanol,
5,5,5-Trifluor-1-pentanol,
4,4,5,5,5-Pentafluor-1-pentanol,
2,2,3,3,4,4,5,5-Octafluor-1-pentanol,
6,6-Difluor-1-hexanol,
7,7, 7-Trifluor-1-heptanol,
1,1,1 -Trifluor-2-octanol,
2,2,3,3-Tetrafluor-1-octanol.

**9.** Das Verfahren nach Anspruch 6, wobei das Lösungsmittel 2,2,2-Trifluorethanol ist.

**10.** Das Verfahren nach Anspruch 1, wobei die Proteinfibrillen aus Lysozymfibrillen, Alzheimer-β-amyloidfibrillen, Prionfibrillen, Insulinfibrillen, bovinen α-Lactalbuminfibrillen, S100A8-Fibrillen, S100A9-Fibrillen und α-Synucleinfibrillen ausgewählt sind.

**11.** Das Verfahren nach Anspruch 1, wobei das Metall aus einem Edelmetall, wie z.B. Silver, Gold oder Platin, und Kupfer ausgewählt ist.

**12.** Das Verfahren nach Anspruch 1, wobei das Metallsalz aus einem Nitrat, Nitrit, Carbonat, Chlorid, Bromid, Fluorid, Iodid, Acetat, Sulfat ausgewählt ist.

**13.** Das Verfahren nach Anspruch 1, wobei das Metall Silber ist.

**14.** Das Verfahren nach Anspruch 1, wobei das Metall Silber ist und das Lösungsmittel 2,2,2-Trifluorethanol ist.

**Revendications**

1. Procédé de fabrication de nanofils métalliques, ledit procédé comprenant l'incubation de fibrilles protéiques dans une solution de sel de métal dans un solvant, ledit solvant ayant une constante hydrophobe, log P, comprise entre 0 et 3,0 et ayant en outre un potentiel de réduction standard, $E_0$, compris entre 0 volt et 1,5 volt, offrant un double effet en favorisant la formation de fibrilles protéiques de taille adéquate et en se comportant comme un agent réducteur permettant la formation de nanofils métalliques sur les matrices de fibrilles protéiques.

2. Procédé selon la revendication 1 comprenant en outre la digestion par la protéinase de la matrice de fibrilles protéiques après la formation des nanofils métalliques.

3. Procédé selon la revendication 2 dans lequel la digestion par la protéinase est réalisée à l'aide d'une protéinase choisie parmi la protéinase K, une sérine protéase telle que la trypsine, l'α-chymotrypsine, la β-chymotrypsine et la subtilisine ; une cystéine protéase telle que la bromélaïne, la papaïne, la chymopapaïne, la ficine et la sortase A, et une protéase aspartique telle que la rennine et la pepsine.

4. Procédé selon la revendication 1 dans lequel le solvant a une constante hydrophobe, log P, qui est comprise entre 0 et 3,0, de préférence entre 0,2 et 1,0, et encore plus préférablement entre 0,3 et 0,5.

5. Procédé selon la revendication 1 dans lequel le solvant a un potentiel de réduction standard, $E_0$, compris entre 0 volt et 1,5 volt, de préférence entre 0 volt et 0,8 volt, par exemple entre 0,1 volt et 0,7 volt, ou encore plus préférablement entre 0,2 volt et 0,6 volt.

6. Procédé selon la revendication 1 dans lequel le solvant est un alcool fluoré.

7. Procédé selon la revendication 1 dans lequel le solvant est choisi parmi un éthanol, un propanol, un butanol, un pentanol, un hexanol, un heptanol ou un octanol fluoré.

8. Procédé selon la revendication 1 dans lequel le solvant est choisi parmi
   le 2-fluoroéthanol,
   le 2,2-difluoroéthanol,
   le 2,2,2-trifluoroéthanol,
   le 1,1,1-trifluoro-2-propanol,
   le 3,3,3-trifluoro-1-propanol,
   l'hexafluoro-2-propanol,
   le 2,2,3,3-tétrafluoro-1-propanol,
   le 2,2,3,3,3-pentafluoro-1-propanol,
   le 4,4,4-trifluoro-1-butanol,
   le 2,2,3,4,4,4-hexafluoro-1-butanol,
   le 2,2,3,3,4,4,4-heptafluoro-1-butanol,
   le 3,3,4,4,4-pentafluoro-2-butanol,
   le 1,1,1,3,3-pentafluoro-2-butanol,
   le 5,5,5-trifluoro-1-pentanol,
   le 4,4,5,5,5-pentafluoro-1-pentanol,
   le 2,2,3,3,4,4,5,5-octafluoro-1-pentanol,
   le 6,6-difluoro-1-hexanol,
   le 7,7,7-trifluoro-1-heptanol,
   le 1,1,1-trifluoro-2-octanol,
   le 2,2,3,3-tétrafluoro-1-octanol.

9. Procédé selon la revendication 6 dans lequel le solvant est du 2,2,2-trifluoroéthanol.

10. Procédé selon la revendication 1 dans lequel les fibrilles protéiques sont choisies parmi les fibrilles de lysozyme, les fibrilles β-amyloïdes associées à la maladie d'Alzheimer, les fibrilles associées au prion, les fibrilles d'insuline, les fibrilles d'alpha-lactalbumine bovine, les fibrilles S100A8, les fibrilles S100A9 et les fibrilles d'alpha-synucléine.

11. Procédé selon la revendication 1 dans lequel le métal est choisi parmi un métal noble, tel que de l'argent, de l'or ou du platine et du cuivre.

12. Procédé selon la revendication 1 dans lequel le sel de métal est choisi parmi un nitrate, un nitrite, un carbonate, un chlorure, un bromure, un fluorure, un iodure, un acétate et un sulfate.

13. Procédé selon la revendication 1 dans lequel le métal est de l'argent.

14. Procédé selon la revendication 1 dans lequel le métal est de l'argent et le solvant est du 2,2,2-trifluoroéthanol.

# Figure 1

Ø 2-4 nm — Amyloid fibrils

TFE / Ag+

Ø 6-9 nm — Amyloid scaffold

57 °C, 48h

Ø 6-9 nm — Amyloid scaffold filled with silver

pH 7,4; 37 °C / Protease K

Ø 1-2 nm — Silver nanowire

# Figure 2

# Figure 3

# Figure 4

# Figure 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **Braun, E. ; Eichen. Y. ; Sivan, U. ; Ben-Yoseph, G.** DNA-templated assembly and electrode attachment of a conducting silver wire. *Nature,* 1998, vol. 391, 775-778
- **Stoltenberg, R. M. ; Woolley, A. T.** DNA-templated nanowire fabrication. *Biomed. Microdevices,* 2004, vol. 6, 105-111
- **Berti, L. ; Alessandrini, A. ; Facci, P.** DNA-templated photoinduced silver deposition. *J. Am. Chem. Soc.,* 2005, vol. 127, 11216-11217
- **Knez, M et al.** Biotemplate synthesis of 3-nm nickel and cobalt nanowires. *Nano Lett.,* 2003, vol. 3, 1079-1082
- **Baici, S. et al.** Copper nanowires within the central channel of tobacco mosaic virus particles. *Electrochim. Acta,* 2006, vol. 51, 6251-6257
- **Mao, C. et al.** Virus-based toolkit for the directed synthesis of magnetic and semiconducting nanowires. *Science,* 2004, vol. 303, 213-217
- **Patolsky. F. ; Weizmann, Y. ; Willner, I.** Actin-based metallic nanowires as bionanotransporters. *Nat. Mater.,* 2004, vol. 3, 692-695
- **Scheibel, T et al.** Conducting nanowires built by controlled self-assembly of amyloid fibers and selective metal deposition. *Proc. Natl. Acad. Sci. USA,* 2003, vol. 100, 4527-4532
- **Reches, M. ; Gazit, E.** Casting metal nanowires within discrete self-assembled peptide nanotubes. *Science,* 2003, vol. 300, 625-627
- **Dobson, C. M.** Protein folding and its links with human disease. *Biochem. Soc. Symp.,* 2001, vol. 68, 1-26
- **Chiti, F. ; Dobson, C. M.** Protein misfolding, functional amyloid, and human disease. *Annu. Rev. Biochem.,* 2006, vol. 75, 333-366

- **Jimenez, J. L. et al.** Cryo-electron microscopy structure of an SH3 amyloid fibril and model of the molecular packing. *EMBO J.,* 1999, vol. 18, 815-821
- **Morozova-Roche, L. A. et al.** Amyloid fibril formation and seeding by wild-type human lysozyme and its disease-related mutational variants. *J. Struct. Biol.,* 2000, vol. 130, 339-351
- **Krebs, M. R. et al.** Formation and seeding of amyloid fibrils from wild-type hen lysozyme and a peptide fragment from the β-domain. *J Mol. Biol.,* 2000, vol. 300, 541-549
- **Pastoriza-Santos, L ; Liz-Marzán, L. M.** Reduction of silver nanoparticles in DMF. Formation of monolayers and stable colloids. *Pure Appl. Chem.,* 2000, vol. 72, 83-90
- **LeVine, H. 3rd.** Thioflavine T interaction with synthetic Alzheimer's disease beta-amyloid peptides: detection of amyloid aggregation in solution. *Protein Sci.,* 1993, vol. 2, 404-410
- **Krebs, M. R. ; Bromley, E. H. ; Donald, A. M.** The Binding of thioflavin-T to amyloid fibrils: localisation and implications. *J. Struct. Biol.,* 2005, vol. 149, 30-37
- **Perutz, M. F. ; Finch, J. T. ; Berriman, J. ; Lesk, A.** Amyloid fibers are water-filled nanotubes. *Proc. Natl. Acad. Sci. USA,* 2002, vol. 99, 5591-5595
- **Olofsson, A.** Lindhagen-Persson, M., Sauer-Eriksson, A. E. & Ohman A. Amide solvent protection analysis demonstrate that Amyloid-β (1-40) and Amyloid-β (1-42) form different fibrillar structures under identical conditions. *Biochem J.,* 2007, vol. 404, 63-70
- **Petkova, A. T. ; Yau, W. M. ; Tycko, R.** Experimental constraints on quaternary structure in Alzheimer's β-amyloid fibrils. *Biochemistry,* 2006, vol. 45, 498-512